# EUROPEAN PATENT APPLICATION

(11) **EP 4 376 568 A1**
(43) Date of publication of application: **29.05.2024**
(21) Application number: 23211234.2
(22) Date of filing: 21.11.2023
(51) Int. Cl.: H10B 53/40, H10B 53/50, H10B 12/00, H01L 21/18

(54) **SEMICONDUCTOR DEVICE INCLUDING VERTICAL CHANNEL TRANSISTOR, BIT LINE AND PERIPHERAL GATE**

(30) Priority: 22.11.2022 KR 20220157644
(71) Applicant: Samsung Electronics Co., Ltd., Suwon-si, Gyeonggi-do 16677 (KR)
(72) Inventor: SHIN, Joongchan, Suwon-si, 16677 (KR); LEE, Kiseok, Suwon-si, 16677 (KR); PARK, Seokhan, Suwon-si, 16677 (KR); SHIN, Seokho, Suwon-si, 16677 (KR)
(74) Representative: Marks & Clerk LLP

(57) **Abstract**

A semiconductor device includes a vertical channel transistor including a vertical channel region extending in a vertical direction and a cell gate electrode facing a first side surface of the vertical channel region. A bit line is electrically connected to the vertical channel transistor at a level that is lower than a level of the vertical channel transistor. A peripheral semiconductor body has at least a portion thereof disposed on a same level as the vertical channel region. Peripheral source/drain regions are disposed in the peripheral semiconductor body and are spaced apart from each other in a horizontal direction. A peripheral channel region is disposed between the peripheral source/drain regions in the peripheral semiconductor body. A peripheral gate is disposed below the peripheral semiconductor body. At least a portion of the peripheral gate is disposed on a same level as at least a portion of the bit line.

## Description

### TECHNICAL FIELD

The present disclosure relates to a semiconductor device and, more specifically, to a semiconductor device including a vertical channel transistor, a bit line and a peripheral gate, and a method of manufacturing the same.

### DISCUSSION OF THE RELATED ART

Research has been conducted to reduce sizes of elements included in a semiconductor device and to increase the performance thereof. For example, in a dynamic random-access memory (DRAM), research has been conducted to reliably and stably form elements having reduced sizes, but as the sizes of the elements decreases, it has been difficult to implement transistors having a desired degree of performance.

### SUMMARY

A semiconductor device includes a vertical channel transistor including a vertical channel region extending in a vertical direction and a cell gate electrode facing a first side surface of the vertical channel region. A bit line is electrically connected to the vertical channel transistor at a level that is lower than a level of the vertical channel transistor. A peripheral semiconductor body has at least a portion thereof disposed at a same level as the vertical channel region. Peripheral source/drain regions are disposed in the peripheral semiconductor body and are spaced apart from each other in a horizontal direction. A peripheral channel region is disposed between the peripheral source/drain regions in the peripheral semiconductor body. A peripheral gate is disposed below the peripheral semiconductor body. At least a portion of the peripheral gate is disposed at a same level as at least a portion of the bit line.

A semiconductor device includes a vertical channel transistor including a first cell source/drain region, a second cell source/drain region spaced apart from the first cell source/drain region in a vertical direction on the first cell source/drain region, a vertical channel region disposed between the first and second cell source/drain regions, and a cell gate that is in contact with a first side surface of the vertical channel region. A peripheral transistor includes peripheral source/drain regions that are spaced apart from each other in a horizontal direction. A peripheral channel region is disposed between the peripheral source/drain regions. A peripheral gate is disposed below the peripheral channel region. A bit line is disposed at a level that is lower than a level of the vertical channel transistor and is electrically connected to the first cell source/drain region. A connection structure includes a first lower connection wiring disposed at a level that is lower than a level of the bit line and the peripheral gate. A first peripheral contact plug is disposed between the first lower connection wiring and the peripheral transistor and electrically connects the first lower connection wiring to the peripheral transistor.

A semiconductor device includes a cell semiconductor body. A peripheral semiconductor body is disposed at substantially a same level as the cell semiconductor body. A cell gate is in contact with a first side surface of the cell semiconductor body. A peripheral gate is in contact with a lower surface of the peripheral semiconductor body. A bit line is disposed at a level that is lower than a level of the cell semiconductor body. A contact structure is disposed at a level that is higher than a level of the cell semiconductor body. At least a portion of the peripheral gate is disposed at a same level as at least a portion of the bit line.

The invention also provides a method of forming the semiconductor device. At least some of the above and other features of the invention are set out in the claims.

### BRIEF DESCRIPTION OF DRAWINGS

The above and other aspects and features of the present disclosure will be more clearly understood from the following detailed description, taken in combination with the accompanying drawings, in which:
FIGS. 1A and 1B are plan views illustrating a semiconductor device according to an example embodiment of the present disclosure;
FIGS. 2A to 2C are cross-sectional diagrams illustrating a semiconductor device according to an example embodiment of the present disclosure;
FIGS. 2D to 2F are cross-sectional diagrams illustrating a modified example of a semiconductor device;
FIG. 3 is a cross-sectional diagram illustrating a modified example of a semiconductor device;
FIG. 4 is a flowchart illustrating processes of a method of manufacturing a semiconductor device according to an example embodiment of the present disclosure;
FIGS. 5Ato 5C, 6Ato 6C, 7, 8Ato 8C, 9Ato 9C, 10A to 10C, 10A to 11C and 12Ato 12C are cross-sectional diagrams illustrating a method of manufacturing a semiconductor device according to an example embodiment of the present disclosure; and
FIGS. 13A to 13C, and 14A to 14C are cross-sectional diagrams illustrating a modified example of a method of manufacturing a semiconductor device.

### DETAILED DESCRIPTION

Hereinafter, embodiments of the present disclosure will be described as follows with reference to the accompanying drawings. Hereinafter, terms such as "upper," "middle," and "lower" may be replaced with other terms such as "first", "second" and "third" and used to describe elements of the disclosure. Terms such as "first", "first lower", "first intermediate", "first upper", "second", "second lower", "second intermediate", "second upper", "third", "third lower", "third intermediate", and "third upper" may be used to describe various elements, but the elements are not necessarily limited by the above terms. For example, a "first element" may be referred to as a "second element." Likewise, the "second lower element" may be referred to as a "first element" and the "second upper element" may be referred to as a "first element." Among the elements, elements referred to as "insulating layers" may be distinguished from each other by reference numerals.

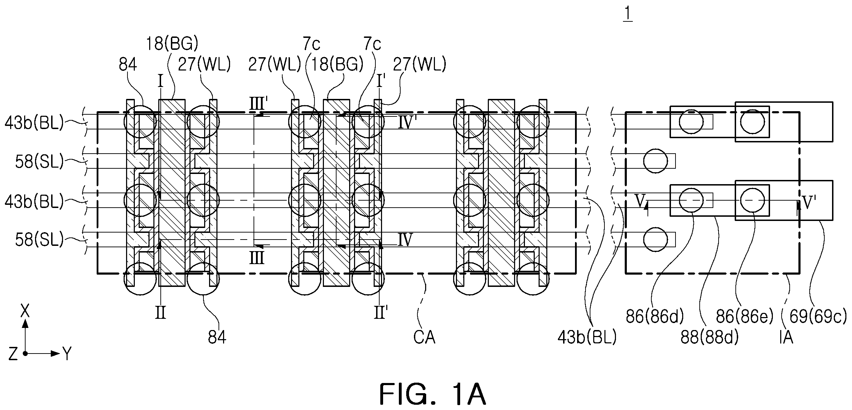

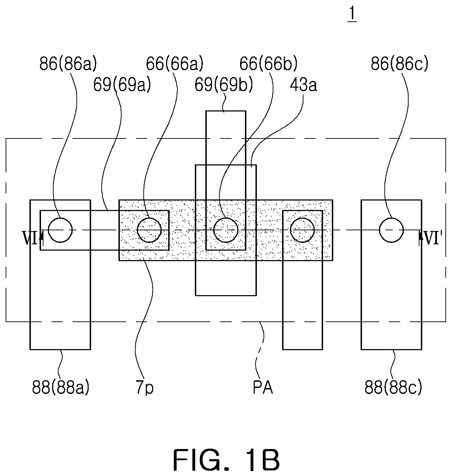

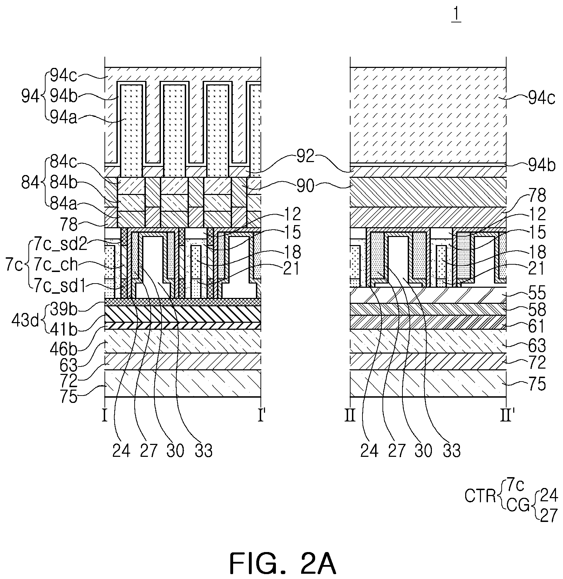

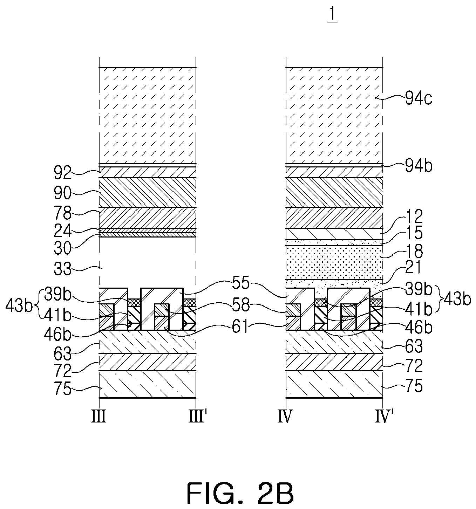

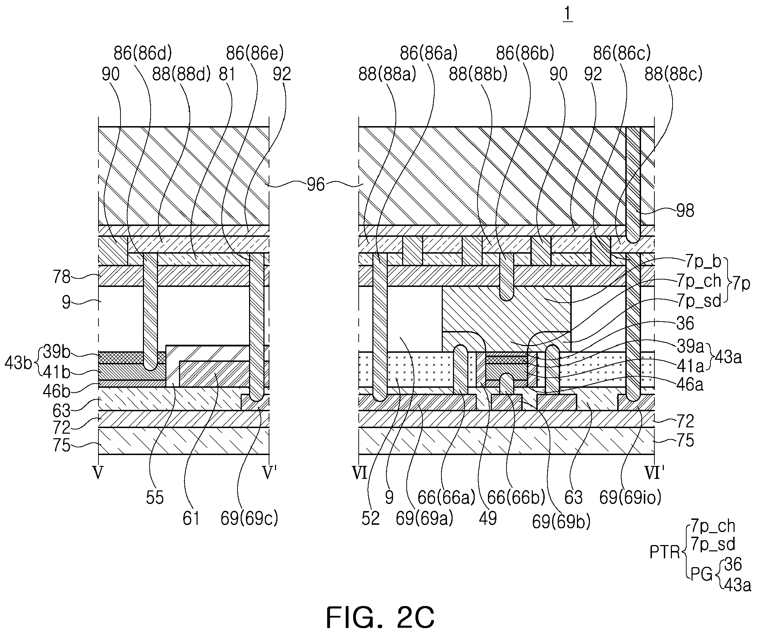

An example of a semiconductor device will be described with reference to FIGS. 1A, 1B, 2A, 2B, and 2C. Among FIGS. 1A to 2C, FIG. 1A is a diagram illustrating a cell array region and a connection region of a semiconductor device according to an example embodiment, and FIG. 1B is a diagram illustrating a cell array region and a connection region of a semiconductor device according to an example embodiment, FIG. 2A is a cross-sectional diagram illustrating regions taken along lines I-I' and II-II' in FIG. 1A, FIG. 2B is a cross-sectional diagram illustrating regions taken along lines III-III' and IV-IV' in FIG. 1A, FIG. 2C is a cross-sectional diagram illustrating regions taken along line V-V' in FIG. 1A and line VI-VI' in FIG. 1B.

Referring to FIGS. 1A, 1B, 2A, 2B, and 2C, a semiconductor device 1, according to an example embodiment, may include a cell array region CA, a connection region IA adjacent to the cell array region CA, and a peripheral region PA.

The cell array region CA may be a memory cell array region in which memory cells for storing data are arranged, the peripheral region PA may be a peripheral circuit region including a peripheral circuit, and the connection region IA may be a region disposed between the peripheral region PA and the cell array region CA.

The semiconductor device 1 may include cell semiconductor bodies 7c disposed in the cell array region CA and a peripheral semiconductor body 7p disposed in the peripheral region PA.

The cell semiconductor bodies 7c and the peripheral semiconductor body 7p may be disposed at substantially the same level. The cell semiconductor bodies 7c may be arranged in a first horizontal direction X and a second horizontal direction Y perpendicular to the first horizontal direction X.

The cell semiconductor bodies 7c and the peripheral semiconductor body 7p may be formed of a same semiconductor material. For example, the cell semiconductor bodies 7c and the peripheral semiconductor body 7p may be formed of a single crystal semiconductor material. The cell semiconductor bodies 7c and the peripheral semiconductor body 7p may include a group IV semiconductor, a group III-V compound semiconductor, or a group II-VI compound semiconductor. The cell semiconductor bodies 7c and the peripheral semiconductor body 7p may be a single crystal semiconductor including silicon, silicon carbide, germanium, and/or silicon-germanium. The cell semiconductor bodies 7c may be referred to as a cell semiconductor pattern or a cell silicon pattern, and the peripheral semiconductor body 7p may be referred to as a peripheral semiconductor pattern or a peripheral silicon pattern.

The semiconductor device 1 may include a first cell source/drain region 7c_sd1, a second cell source/drain region 7c_sd2, and a cell vertical channel region 7c_ch may be further included.

Within each of the cell semiconductor bodies 7c, the first cell source/drain region 7c_sd1 may be disposed in a lower region of the cell semiconductor body 7c, the second cell source/drain region 7c_sd2 may be disposed in an upper region of the cell semiconductor body 7c, and the cell vertical channel region 7c_ch may be disposed between the first and second cell source/drain regions 7c_sd1 and 7c_sd2. The second cell source/drain region 7c_sd2 may be disposed on the first cell source/drain region 7c_sd1 and may be disposed at a level that is higher than a level of the first cell source/drain region 7c_sd1. The second cell source/drain region 7c_sd2 may be spaced apart from the first cell source/drain region 7c_sd1 in a vertical direction Z. The cell vertical channel region 7c_ch may be referred to as a "cell channel region" or a "vertical channel region."

The semiconductor device 1 further includes a peripheral source/drain region 7p_sd and a peripheral channel region 7p_ch disposed in the peripheral semiconductor body 7p. The peripheral channel region 7p_ch is disposed between the peripheral source/drain regions 7p_sd.

The peripheral source/drain regions 7p_sd may be disposed in a lower region of the peripheral semiconductor body 7p. In example embodiments, the peripheral source/drain regions 7p_sd may extend from a portion disposed in the lower region of the peripheral semiconductor body 7p to an intermediate region of the peripheral semiconductor body 7p, or to an upper region of the peripheral semiconductor body 7p.

The peripheral source/drain regions 7p_sd are spaced apart from each other in a horizontal direction. The peripheral source/drain regions 7p_sd may be disposed at substantially the same level as one another. The peripheral channel region 7p_ch is disposed between the peripheral source/drain regions 7p_sd. The peripheral channel region 7p_ch may also be referred to as a horizontal channel region.

The semiconductor device 1 may further include a peripheral body region 7p_b disposed on the peripheral source/drain regions 7p_sd and the peripheral channel region 7p_ch in the peripheral semiconductor body 7p. The peripheral body region 7p_b may be a well region or a peripheral well region. Within the peripheral semiconductor body 7p, the peripheral source/drain regions 7p_sd and the peripheral channel region 7p_ch may be disposed below the peripheral body region 7p_b. The peripheral body region 7p_b may also be referred to as a peripheral well region.

The semiconductor device 1 further includes cell gates CG. Each of the cell gates CG include a cell gate electrode 27 facing the first side surface of the cell vertical channel region 7c_ch in the cell semiconductor body 7c, and may include a cell gate dielectric layer 24 including a portion interposed between the cell gate electrode 27 and the cell semiconductor body 7c. The cell gate dielectric layer 24 may be in contact with the first side surface of the cell vertical channel region 7c_ch in the cell semiconductor body 7c.

The cell gates CG, the first and second cell source/drain regions 7c_sd1 and 7c_sd2, and the cell vertical channel region 7c_ch may be included in a cell vertical channel transistor CTR. The cell vertical channel transistor CTR may also be referred to as a cell transistor, a vertical transistor, or a vertical channel transistor.

Lower ends of the cell gate electrodes 27 may be disposed at a level that is higher than a level of lower ends of the cell semiconductor bodies 7c. Upper ends of the cell gate electrodes 27 may be disposed at a level that is lower than a level of upper ends of the cell semiconductor bodies 7c.

The cell gate dielectric layer 24 may include silicon oxide and/or a high-κ dielectric material. The high-κ dielectric material may be a material having a dielectric constant that is higher than that of silicon oxide. The high-κ dielectric material may include a metal oxide or a metal oxynitride. For example, the high-κ dielectric material may be formed of HfO₂, HfSiO, HfSiON, HfTaO, HfTiO, HfZrO, ZrO₂, Al₂O₃, or a combination thereof, but an example embodiment thereof is not necessarily limited thereto. The cell gate dielectric layer 24 may be formed as a single layer or multiple layers formed of the above materials.

The cell gate electrodes 27 may be word lines WL. The cell gate electrodes 27 may include doped polysilicon, metal, conductive metal nitride, metal-semiconductor compound, conductive metal oxide, conductive graphene, carbon nanotube, or a combination thereof. For example, the cell gate electrodes 27 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, or a combination thereof, but an example embodiment thereof is not necessarily limited thereto. The cell gate electrodes 27 may include a single layer or multiple layers formed of the above materials.

The semiconductor device 1 may further include back gates (15 and 18). Each of the back gates (15 and 18) may include a back gate electrode 18 facing the second side surface of the cell vertical channel region 7c_ch in the cell semiconductor body 7c, and a back gate dielectric layer 15 including a portion interposed between the back gate electrode 18 and the cell semiconductor body 7c. The back gate dielectric layer 15 may be in contact with the second side surface of the cell vertical channel region 7c_ch in the cell semiconductor body 7c.

A lower end of the back gate electrode 18 may be disposed at a level that is higher than a level of lower ends of the cell semiconductor bodies 7c. An upper end of the back gate electrode 18 may be disposed at a level that is lower than a level of upper ends of the cell semiconductor bodies 7c. An upper end of the back gate electrode 18 may be disposed at a level that is different from a level of an upper end of the cell gate electrode 27. For example, the upper end of the back gate electrode 18 may be disposed at a level that is lower than a level of the upper end of the cell gate electrode 27.

The back gate dielectric layer 15 may include silicon oxide and/or a high-κ dielectric material. The back gate electrode 18 may include doped polysilicon, metal, conductive metal nitride, metal-semiconductor compound, conductive metal oxide, conductive graphene, carbon nanotube, or a combination thereof.

The back gate electrode 18 may prevent a floating body effect occurring in the cell vertical channel region 7c_ch of the cell vertical channel transistor CTR, and may prevent the threshold voltage of the cell vertical channel transistor (CTR) from being changed. Accordingly, the back gate electrode 18 may stably operate the cell vertical channel transistor CTR.

The semiconductor device 1 may further include an insulating layer 21 disposed below the back gate electrode 18 and an insulating layer 12 disposed on the back gate electrode 18. The back gate dielectric layer 15 may extend to a region between the back gate electrode 18 and the insulating layer 12 from a portion in contact with the cell semiconductor body 7c.

The semiconductor device 1 may include an insulating layer 33 disposed between a pair of cell gate electrodes 27 adjacent to each other between a pair of adjacent cell semiconductor bodies 7c and an insulating layer 30 covering the side surface and upper surface of the insulating layer 33. Lower ends of the cell gate electrodes 27 may be covered by the insulating layers 30 and 33. In an example embodiment, the shape of the insulating layers 30 and 33 is not necessarily limited to the shape illustrated in the drawings, for example, the shape illustrated in FIGS. 2A and 2B, and may be modified into various shapes.

The semiconductor device 1 further includes a bit line 43b disposed at a level that is lower than a level of the cell vertical channel transistor CTR and a peripheral gate PG disposed below the peripheral semiconductor body 7p. At least a portion of the peripheral gate PG is disposed at the same level as a level of at least a portion of the bit line 43b.

The peripheral gate PG may be disposed in the peripheral region PA. The peripheral gate PG may include a peripheral gate electrode 43a disposed below the peripheral semiconductor body 7p and a peripheral gate dielectric layer 36 disposed between the peripheral gate electrode 43a and the peripheral semiconductor body 7p. The peripheral gate PG, the peripheral channel region 7p_ch, and the peripheral source/drain regions 7p_sd may be included in a peripheral transistor PTR.

The peripheral gate dielectric layer 36 may include silicon oxide and/or a high-κ dielectric material. The peripheral gate electrode 43a may include a plurality of peripheral conductive layers 41a and 39a that are sequentially stacked. For example, the peripheral conductive layers 41a and 39a of the peripheral gate electrode 43a may include a peripheral upper conductive layer 39a in contact with the peripheral gate dielectric layer 36 and a peripheral lower conductive layer 41a below the peripheral upper conductive layer 39a. The peripheral upper conductive layer 39a may be a work function control layer. Each of the conductive layers 41a and 39a in the peripheral gate electrode 43a may be doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotube, or a combination thereof, but an example embodiment thereof is not necessarily limited thereto. Each of the peripheral conductive layers 41a and 39a may include a single layer or multiple layers formed of the aforementioned materials.

The bit line 43b may be disposed in the cell array region CA and may extend into the connection region IA. The bit line 43b may be in contact with the cell semiconductor bodies 7c. The bit line 43b may be electrically connected to the first cell source/drain regions 7c_sd1 in the cell semiconductor bodies 7c.

The bit line 43b may include a plurality of bit line conductive layers 41b and 39b that are sequentially stacked. For example, the bit line conductive layers 41b and 39b may include an bit line upper conductive layer 39b electrically connected to the first cell source/drain regions 7c_sd1 and a bit line lower conductive layer 41b disposed below the bit line upper conductive layer 39b. Each of the bit line conductive layers 41b and 39b may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotube, or a combination thereof, but an example embodiment thereof is not necessarily limited thereto. Each of the bit line conductive layers 41b and 39b may include a single layer or multiple layers formed of the aforementioned materials.

At least a portion of the peripheral gate electrode 43a may be disposed at the same level as at least a portion of the bit line 43b. At least a portion of the peripheral gate electrode 43a may include a same material as that of at least a portion of the bit line 43b.

The bit line conductive layers 41b and 39b and the peripheral conductive layers 41a and 39a may be formed of a same material and may have the same thickness.

One of the bit line conductive layers 41b and 39b and one of the peripheral conductive layers 41a and 39a may be formed of the same material. For example, the bit line lower conductive layer 41b and the peripheral lower conductive layer 41a may be formed of the same material and may have the same thickness.

The semiconductor device 1 may further include a bit line capping pattern 46b aligned with the bit line 43b below the bit line 43b and a peripheral gate capping pattern 46a aligned with the peripheral gate electrode 43a below the peripheral gate electrode 43a. The bit line capping pattern 46b and the peripheral gate capping pattern 46a may be an insulating layer including a same insulating material, for example, silicon nitride.

The semiconductor device 1 may further include a gate spacer 49 disposed on side surfaces of the peripheral gate electrode 43a and the peripheral gate capping pattern 46a. The gate spacer 49 may be an insulating layer including silicon oxide, low-κ dielectric material, and/or a high-κ dielectric material. The low-κ dielectric material may be a material having a dielectric constant that is lower than that of silicon oxide.

The semiconductor device 1 may further include a device isolation layer 9 disposed on a side surface of the peripheral semiconductor body 7p. The device isolation layer 9 may define the peripheral semiconductor body 7p. The device isolation layer 9 may be formed of an insulating material such as silicon oxide and/or silicon nitride.

There may be a plurality of bit lines 43b. The plurality of bit lines 43b may be parallel to each other.

The semiconductor device 1 may further include shield patterns 58 disposed between the bit lines 43b and spaced apart from the bit lines 43b. Each of the shield patterns 58 may be disposed between bit lines 43b adjacent to each other.

A vertical thickness of each of the shield patterns 58 may be different from a vertical thickness of each of the bit lines 43b. For example, a vertical thickness of each of the shield patterns 58 may be smaller than a vertical thickness of each of the bit lines 43b.

In example embodiments, "vertical thickness" may refer to a thickness in a vertical direction Z or a distance between an upper surface and a lower surface in the vertical direction Z.

The lower surfaces of the shield patterns 58 may be disposed at a level different from a level of the lower surfaces of the bit lines 43b. For example, lower surfaces of the shield patterns 58 may be disposed at a level that is higher than a level of lower surfaces of the bit lines 43b.

The upper surfaces of the shield patterns 58 may be disposed at a level different from a level of the upper surfaces of the bit lines 43b. For example, upper surfaces of the shield patterns 58 may be disposed at a level that is lower than a level of upper surfaces of the bit lines 43b.

The shield patterns 58 may be formed of a conductive material. For example, the shield patterns 58 may include doped polysilicon, metal, conductive metal nitride, metal-semiconductor compound, conductive metal oxide, graphene, carbon nanotube, or combinations thereof. The shield patterns 58 may screen capacitive coupling between the bit lines 43b adjacent to each other. For example, the shield patterns 58 may reduce RC delay in the bit lines 43b by reducing or blocking parasitic capacitance between the adjacent bit lines 43b.

The semiconductor device 1 may further include insulating layers 55 covering upper surfaces and side surfaces of the insulating layers 61 under the shield patterns 58 and the shield patterns 58, and covering side surfaces of the insulating layers 61. The insulating layers 55 and 61 may cover side surfaces of ends of the bit lines 43b in the connection region IA. The shield patterns 58 may be spaced apart from the bit lines 43b by the insulating layer 55.

The semiconductor device 1 may include an insulating layer 63 disposed below the bit line capping patterns 46b, the insulating layers 55 and 61, the insulating layer 52, and the peripheral gate capping pattern 46a.

The semiconductor device 1 may further include lower wiring structures (66 and 69). The lower wiring structures (66 and 69) may include lower connection wirings 69 and lower contact plugs 66 electrically connected to the lower connection wirings 69 on the lower connection wirings 69. Lower surfaces of the lower connection wirings 69 may be coplanar with a lower surface of the insulating layer 63. The lower connection wirings 69 may be embedded in the insulating layer 63. The lower connection wirings 69 may be disposed in the peripheral region PA and the connection region IA.

In an example, among the lower connection wirings 69 and the lower contact plugs 66, the lower connection wirings 69 and the lower contact plug 66 electrically connected to each other may be integrally formed. For example, in the lower connection wiring 69 and the lower contact plug 66 electrically connected to each other, the lower contact plug 66 may continuously extend from the lower connection wiring 69 without a boundary surface.

In an example, among the lower connection wirings 69 and the lower contact plugs 66, the lower connection wirings 69 and the lower contact plugs 66 electrically connected to each other may be formed by different processes such that a boundary surface may be formed between the lower connection wiring 69 and the lower contact plug 66. For example, an upper surface of the lower connection wiring 69 and a lower surface of the lower contact plug 66 may be in contact with each other.

The lower contact plugs 66 may include a contact plug electrically connecting the peripheral transistor PTR to the peripheral source/drain lower connection wiring 69a between the peripheral transistor PTR and the peripheral source/drain lower connection wiring 69a. For example, the lower contact plugs 66 may include a peripheral source/drain contact plug 66a electrically connected to the peripheral source/drain region 7p_sd and a peripheral gate contact plug 66b electrically connected to the peripheral gate electrode 43a.

The peripheral source/drain contact plug 66a may be in contact with the lower surface of the peripheral source/drain region 7p_sd in the peripheral semiconductor body 7p and may extend into the peripheral source/drain region 7p_sd. An upper end of the peripheral source/drain contact plug 66a may be disposed at a level that is higher than a level of a lower surface of the peripheral semiconductor body 7p, for example, a lower surface of the peripheral source/drain region 7p_sd, and may be disposed at a level that is lower than a level of the upper end of the peripheral source/drain region 7p_sd.

The lower connection wirings 69 may include a peripheral source/drain lower connection wiring 69a electrically connected to the peripheral source/drain contact plug 66a below the peripheral source/drain contact plug 66a, and a peripheral gate lower connection wiring 69b electrically connected to the peripheral gate contact plug 66b below the peripheral gate contact plug 66b.

The lower connection wirings 69 may further include a bit line lower connection wiring 69c disposed in the connection region IA and extending into the peripheral region PA, and a peripheral lower connection wiring 69io in the peripheral region PA.

The semiconductor device 1 may further include an insulating layer 72 disposed below the insulating layer 63 and the lower connection wirings 69 and a base substrate 75 disposed below the insulating layer 72.

The semiconductor device 1 may further include insulating layers 78, 81, and 90 disposed at a level that is higher than levels of the cell semiconductor bodies 7c and the peripheral semiconductor body 7p.

The semiconductor device 1 may further include cell contact structures 84 disposed in the cell array region CA. Among the insulating layers 78, 81, and 90, the insulating layers 78 and 90 may be sequentially stacked in the cell array region CA and the connection region IA adjacent to the cell array region CA.

The cell contact structures 84 may penetrate through the insulating layers 78 and 90 and may be in contact with the cell semiconductor bodies 7c. The cell contact structures 84 may be electrically connected to the second cell source/drain regions 7c_sd2 in the cell semiconductor bodies 7c.

Each of the cell contact structures 84 may include a first contact layer 84a, a second contact layer 84b on the first contact layer 84a, and a third contact layer 84c on the second contact layer 84b.

The first contact layer 84a may be in contact with the cell semiconductor body 7c and may be electrically connected to the second cell source/drain region 7c_sd2. The first contact layer 84a may be formed of a silicon layer.

A vertical central axis between side surfaces of the first contact layer 84a might not be aligned with a vertical central axis between side surfaces of the cell semiconductor body 7c. Side surfaces of the first contact layer 84a might not be aligned with side surfaces of the cell semiconductor body 7c.

In an example, the first contact layer 84a may include a doped polysilicon layer, for example, a polysilicon layer having N-type conductivity.

In an example, the first contact layer 84a may include a doped epitaxial silicon layer. For example, the first contact layer 84a may have N-type conductivity and may be formed of an epitaxial silicon layer epitaxially grown from the cell semiconductor body 7c.

The second contact layer 84b may include a metal-semiconductor compound layer and/or a conductive barrier layer. For example, the metal-semiconductor compound layer may include WSi, TiSi, TaSi, NiSi, and/or CoSi, and the conductive barrier layer may include TiN, TaN, WN, TiSiN, TaSiN, and/or RuTiN.

The third contact layer 84c may include a conductive material such as tungsten.

The semiconductor device 1 may further include connection structures (86 and 88). The connection structures (86 and 88) may include connection contact plugs 86 and upper connection wirings 88. The connection contact plugs 86 may also be referred to as upper contact plugs.

In an example, among the upper connection wirings 88 and the connection contact plugs 86, the upper connection wiring 88 and the connection contact plug 86 electrically connected to each other may be integrally formed. For example, in the upper connection wiring 88 and the connection contact plug 86 electrically connected to each other, the connection contact plug 86 may continuously extend from the upper connection wiring 88 without a boundary surface.

In an example, among the upper connection wirings 88 and the connection contact plugs 86, the upper connection wirings 88 and the connection contact plugs 86 electrically connected to each other may be formed by different processes such that a boundary surface may be formed between the upper connection wiring 88 and the connection contact plug 86. For example, an upper surface of the upper connection wiring 88 and a lower surface of the connection contact plug 86 may be in contact with each other.

The connection contact plugs 86 may include a first connection contact plug 86a electrically connected to and in contact with the peripheral source/drain lower connection wiring 69a, a second connection contact plug 86b electrically connected to and in contact with the peripheral body region 7p_b of the peripheral semiconductor body 7p, a third connection contact plug 86c electrically connected to and in contact with the peripheral lower connection wiring 69io, a fourth connection contact plug 86d electrically connected to and in contact with the bit line 43b, and a fifth connection contact plug 86e electrically connected to and in contact with the bit line lower connection wiring 69c.

The upper connection wirings 88 may include a first upper connection wiring 88a electrically connected to the first connection contact plug 86a, a second upper connection wiring 88b electrically connected to the second connection contact plug 86b, a third upper connection wiring 88c electrically connected to the third connection contact plug 86c, and a fourth upper connection wiring 88d electrically connected to the fourth and fifth connection contact plugs 86d and 86e.

The first upper connection wiring 88a may extend into the peripheral region PA. The fourth upper connection wiring 88d and the first upper connection wiring 88a may be integrally formed.

The first connection contact plug 86a may electrically connect the peripheral source/drain lower connection wiring 69a to the first upper connection wiring 88a between the peripheral source/drain lower connection wiring 69a and the first upper connection wiring 88a. The first connection contact plug 86a may intersect the upper surface of the peripheral source/drain lower connection wiring 69a, may extend into the peripheral source/drain lower connection wiring 69a, and may be in contact with the peripheral source/drain lower connection wiring 69a. A lower end of the first connection contact plug 86a may be disposed at a level that is lower than a level of an upper surface of the peripheral source/drain lower connection wiring 69a.

The second connection contact plug 86b may electrically connect the peripheral body region 7p_b of the peripheral semiconductor body 7p to the second upper connection wiring 88b between the peripheral body region 7p_b of the peripheral semiconductor body 7p and the second upper connection wiring 88b. The second connection contact plug 86b may intersect the upper surface of the peripheral semiconductor body 7p, may extend into the peripheral semiconductor body 7p, and may be in contact with the peripheral semiconductor body 7p. A lower end of the second connection contact plug 86b may be disposed at a level that is lower than a level of an upper surface of the peripheral semiconductor body 7p.

The third connection contact plug 86c may electrically connect the peripheral lower connection wiring 69io to the third upper connection wiring 88c between the peripheral lower connection wiring 69io and the third upper connection wiring 88c. The third connection contact plug 86c may intersect an upper surface of the peripheral lower connection wiring 69io, may extend into the peripheral lower connection wiring 69io, and may be in contact with the peripheral lower connection wiring 69io.

The fourth connection contact plug 86d may electrically connect the bit line 43b to the fourth upper connection wiring 88d between the bit line 43b and the fourth upper connection wiring 88d. The fourth connection contact plug 86d may intersect the upper surface of the bit line 43b, may extend into the bit line 43b, and may be in contact with the bit line 43b. The fourth connection contact plug 86d may penetrate through the bit line upper conductive layer 39b of the bit line 43b and may be in contact with the bit line lower conductive layer 41b. A lower end of the fourth connection contact plug 86d may be disposed at a level that is lower than a level of an upper surface of the bit line 43b.

The fifth connection contact plug 86e may electrically connect the bit line lower connection wiring 69c to the fourth upper connection wiring 88d between the bit line lower connection wiring 69c and the fourth upper connection wiring 88d. The fifth connection contact plug 86e may intersect the upper surface of the bit line lower connection wiring 69c, may extend into the bit line lower connection wiring 69c, and may be in contact with the bit line lower connection wiring 69c.

Among the insulating layers 78, 81, and 90, the insulating layers 78 and 81 may be sequentially stacked in the peripheral region PA and the connection region IA. The insulating layer 90 may penetrate through the insulating layer 81 on the insulating layer 78, may extend upwardly and may isolate the upper connection wirings 88 from each other.

The semiconductor device 1 may further include an etch stop layer 92 covering the insulating layer 90, the cell contact structures 84, and the connection structures (86 and 88).

The semiconductor device 1 may further include a data storage structure 94 electrically connected to the contact structures 84 in the cell array region CA. The data storage structure 94 may include first electrodes 94a penetrating through the etch stop layer 92 and electrically connected to the contact structures 84, a dielectric layer 94b on the first electrodes 94a, and a second electrode 94c on the dielectric layer 94b.

In an example, the data storage structure 94 may be a capacitor for storing data in DRAM. For example, the dielectric layer 94b of the data storage structure 94 may be a DRAM capacitor dielectric layer, and the dielectric layer 94b may include a high-κ dielectric layer, silicon oxide, silicon nitride, silicon oxynitride, or a combination thereof.

In an example, the data storage structure 94 may be a structure for storing DRAM and other memory data. For example, the data storage structure 94 may be a capacitor disposed between the first and second electrodes 94a and 94c and configured to store data of a ferroelectric memory (FeRAM) including a dielectric layer 94b comprising a ferroelectric layer. For example, the dielectric layer 94b may be a ferroelectric layer for recording data using a polarization state. When the data storage structure 94 is a capacitor for storing data of a ferroelectric memory (FeRAM), the ferroelectric layer of the dielectric layer 94b may include an Hf-based compound, a Zr-based compound, and/or a Hf-Zr-based compound.

The semiconductor device 1 may further include an upper insulating layer 96 disposed on the etch stop layer 92 in the peripheral region PA and the connection region IA and an upper contact plug 98 penetrating through the upper insulating layer 96 and the etch stop layer 92 and electrically connected to the third upper connection wiring 88c.

By providing the vertical channel transistor CTR, the peripheral gate PG, and the bit line 43b and BL as described above, integration density of the semiconductor device 1 may be increased, and electrical performance of the semiconductor device 1 may be increased.

Hereinafter, various modified examples of the elements of the above-described example embodiment will be described. Various modified examples of the elements of the above-described example embodiment described below will be described based on the modified or replaced elements. Also, the elements modified or replaced described below will be described with reference to the drawings, but the elements modified or replaced may be combined with each other or with the elements described above and may be included in the semiconductor device in an example embodiment.

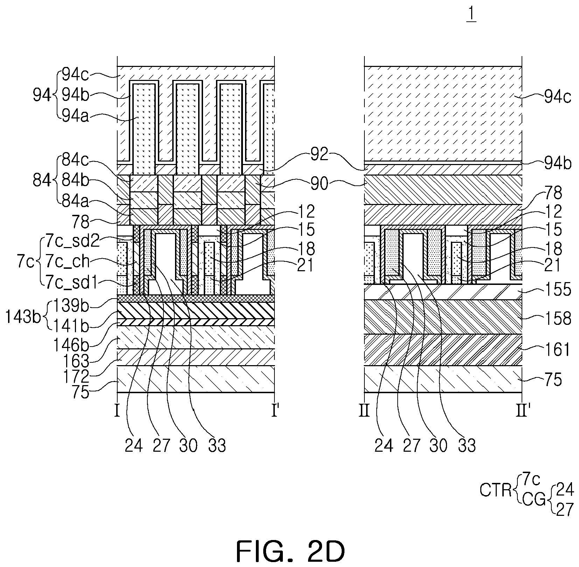

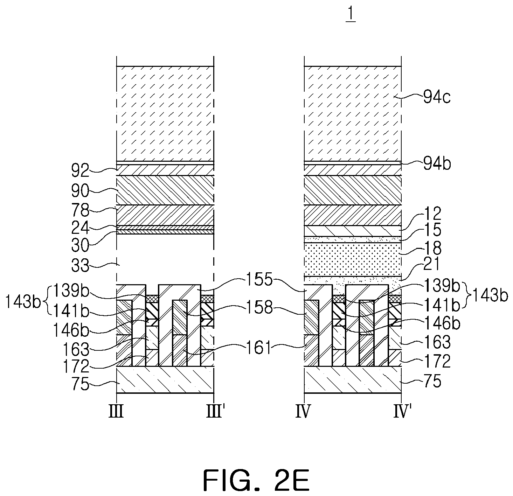

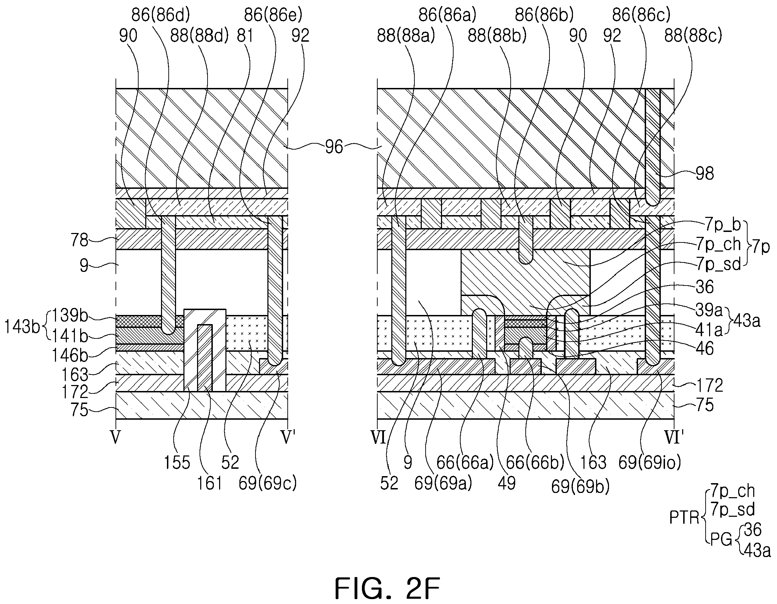

Referring to FIGS. 2D to 2F, a modified example of the shield patterns 58 described above will be described. FIGS. 2D to 2F are cross-sectional diagrams illustrating a modified example of a semiconductor device. FIG. 2D is a cross-sectional diagram illustrating regions taken along lines I-I' and II-II' in FIG. 1A. FIG. 2E is a cross-sectional diagram illustrating regions taken along lines III-III' and IV-IV' in FIG. 1A. FIG. 2F is a cross-sectional diagram illustrating regions taken along lines V-V' in FIG. 1A and VI-VI' in FIG. 1B.

In a modified example, referring to FIGS. 2D to 2F, the shield patterns 58 described above in FIGS. 2A to 2C may be modified into shield patterns 158 as illustrated in FIGS. 2E to 2F.

A vertical thickness of each of the shield patterns 158 may be greater than a vertical thickness of each of the bit lines 43b. Lower surfaces of the shield patterns 158 may be disposed at a level that is lower than a level of lower surfaces of the bit lines 43b. The insulating layers 55 and 61 described above with reference to FIGS. 2A to 2C may be modified to insulating layers 155 penetrating through the insulating layers 163 and 172 and having lower surfaces coplanar with the lower surface of the insulating layer 172.

In an example, the shield patterns 158 may extend to a region below the bit lines 43b from a portion disposed between the bit lines 43b. Accordingly, the shield patterns 158 may be modified to include plate portions connected to each other at a level that is lower than a level of the bit lines 43b and line portions disposed between the bit lines 43b.

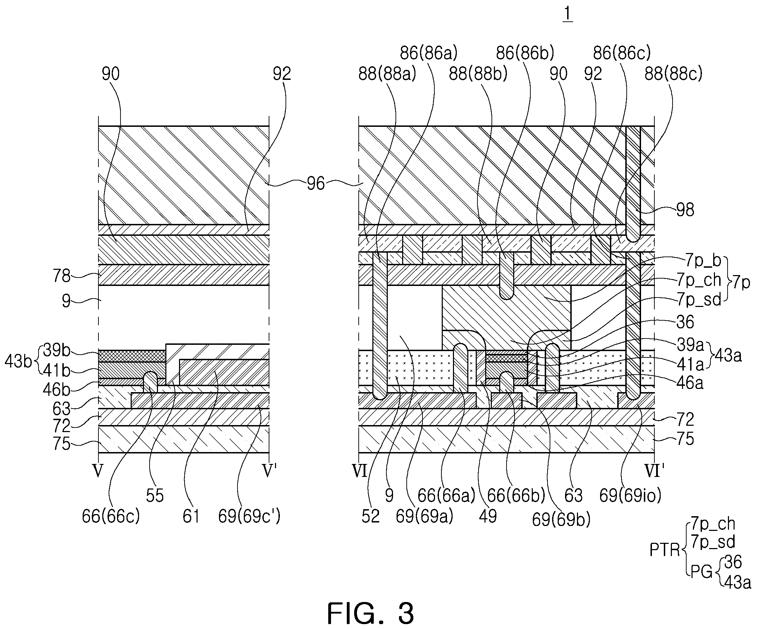

A modified example of a connection structure electrically connected to the bit line 43b among the above-described connection structures (86 and 88) will be described with reference to FIG. 3. FIG. 3 is a cross-sectional diagram illustrating a modified example of a semiconductor device according to an example embodiment, illustrating regions taken along lines V-V' in FIG. 1A and lines VI-VI' in FIG. 1B.

In the modified example, referring to FIG. 3, the bit line lower connection wiring (69c in FIG. 2c) in FIG. 2C may be modified to a bit line lower connection wiring 69c' extending to include a portion overlapping the bit line 43b. The lower contact plugs 66 may further include a bit line lower contact plug 66c electrically connecting the bit line 43b to the bit line lower connection wiring 69c' between the bit line 43b and the bit line lower connection wiring 69c'. The bit line lower contact plug 66c may penetrate through the lower surface of the bit line 43b and may be in contact with the bit line 43b. The bit line lower contact plug 66c may be disposed at a level that is higher than a level of the lower surface of the bit line 43b.

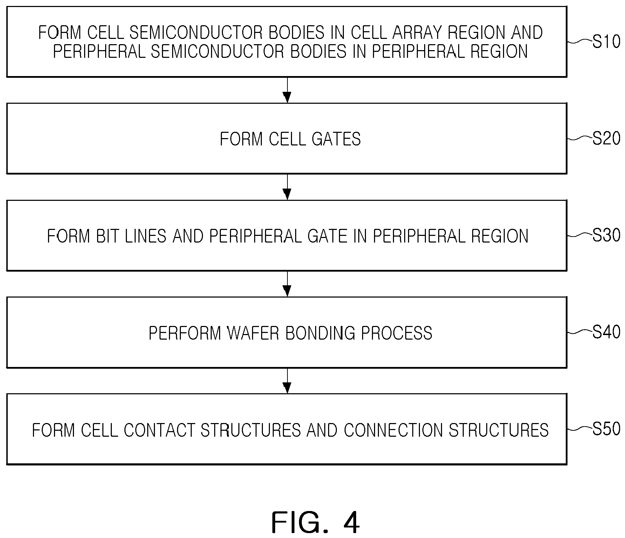

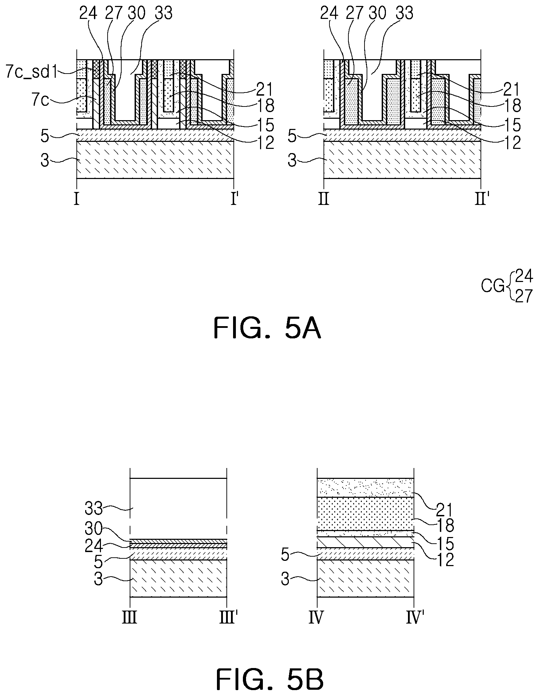

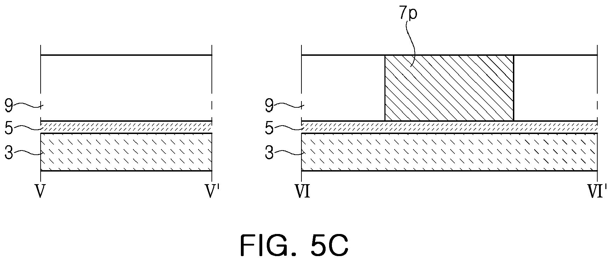

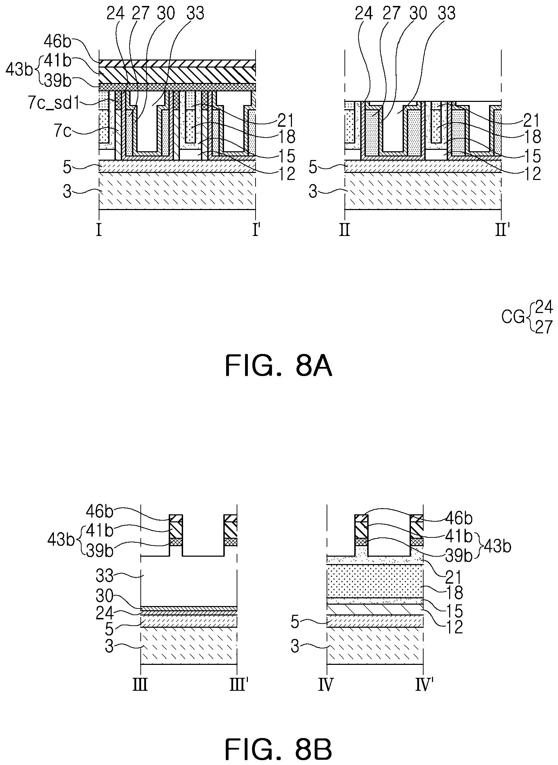

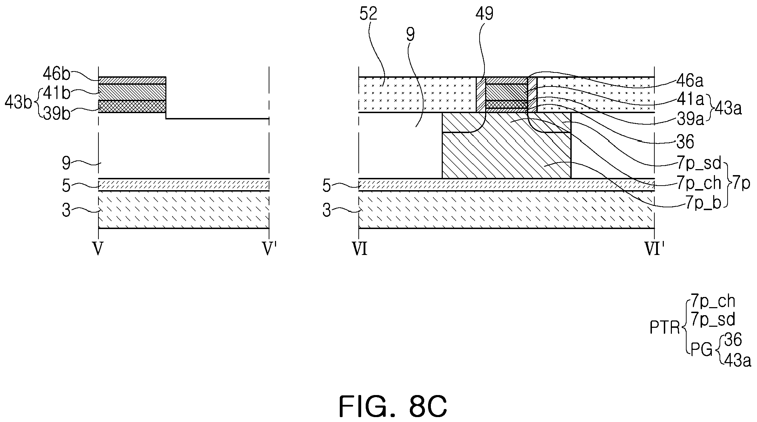

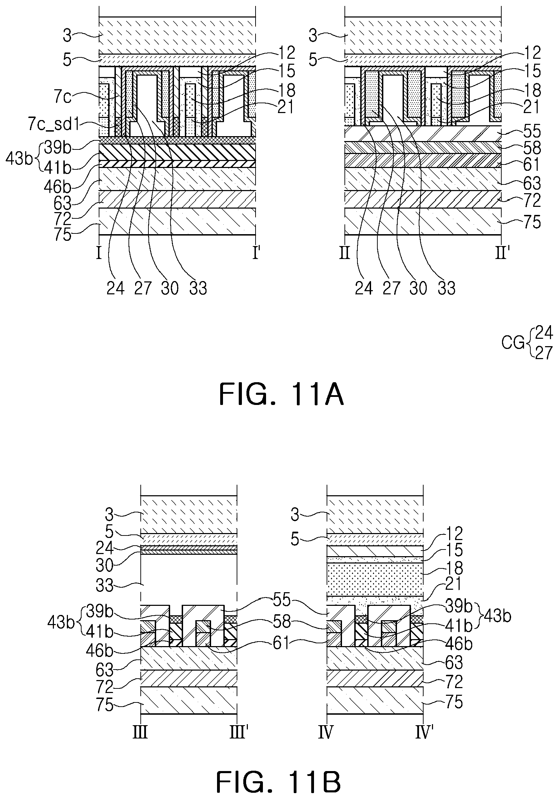

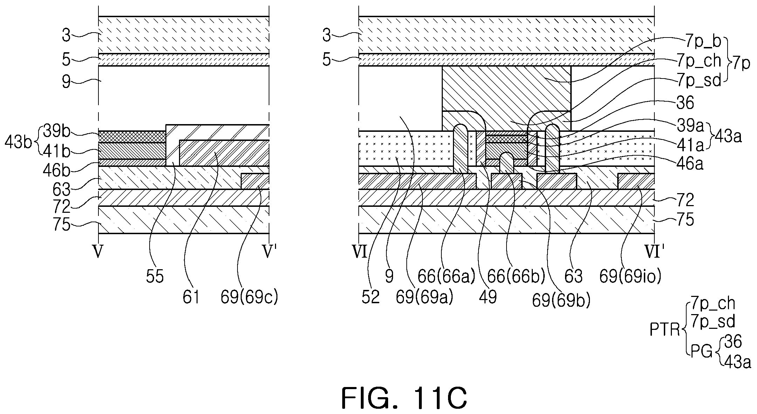

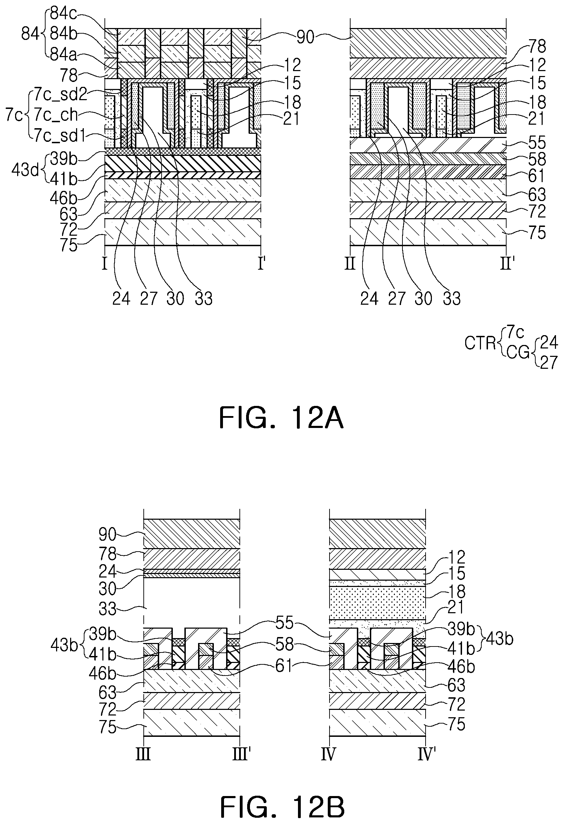

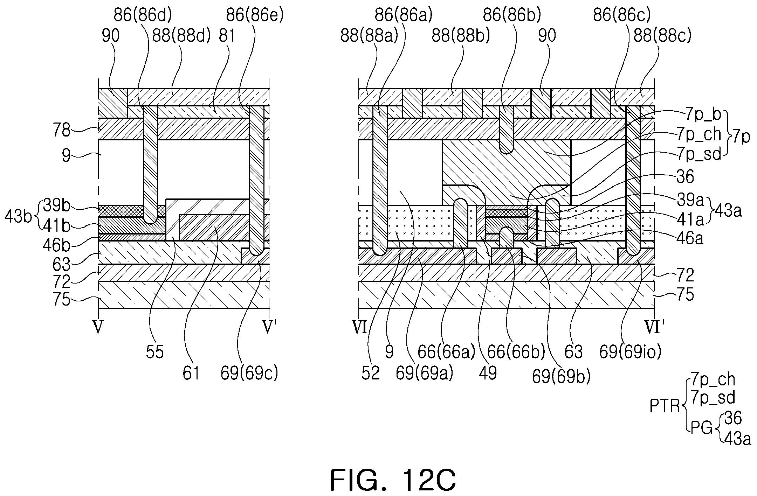

In the description below, an example of a method of manufacturing a semiconductor device according to example embodiments will be described with reference to FIGS. 4 and 5A to 12C, together with FIGS. 1A and 1B. FIG. 4 is a flowchart illustrating processes of a method of manufacturing a semiconductor device according to example embodiments, and FIGS. 5A, 6A, 8A, 9A, 10A, 11A, and 12A are cross-sectional diagrams illustrating regions taken along lines I-I' and II-II', FIGS. 5B, 6B, 8B, 9B, 10B, 11B, and 12B are cross-sectional diagrams illustrating regions taken along lines III-III' and IV-IV' in FIG. 1A, and FIGS. 5C, 6C, 7, 8C, 9C, 10C, 11C, and 12C are cross-sectional diagrams illustrating regions taken along lines V-V' in FIG. 1A and VI-VI' in FIG. 1B.

Referring to FIGS. 1A, 1B, 4, 5A, 5B, and 5C, cell semiconductor bodies 7c in the cell array region CA and peripheral semiconductor bodies 7p in the peripheral region PA may be formed (S10).

The cell semiconductor bodies 7c and the peripheral semiconductor body 7p may be formed using a silicon on insulator (SOI) substrate. For example, in an SOI substrate including a lower substrate 3, an insulating layer 5 on the lower substrate 3, and an upper substrate on the insulating layer 5, by patterning the upper substrate, the cell semiconductor bodies 7c and the peripheral semiconductor body 7p may be formed. Here, the lower substrate 3 and the upper substrate may include semiconductor material layers. Accordingly, the cell semiconductor bodies 7c and the peripheral semiconductor body 7p may be formed of the same semiconductor material. The cell semiconductor bodies 7c and the peripheral semiconductor body 7p may include a group IV semiconductor, a group III-V compound semiconductor, or a group II-VI compound semiconductor. The cell semiconductor bodies 7c and the peripheral semiconductor body 7p may be formed of a single crystal semiconductor including silicon, silicon carbide, germanium, and/or silicon-germanium. For example, the cell semiconductor bodies 7c and the peripheral semiconductor body 7p may be single crystal silicon patterns or single crystal silicon carbide patterns.

A device isolation layer 9 defining the cell semiconductor bodies 7c and the peripheral semiconductor body 7p may be formed on the insulating layer 5. The device isolation layer 9 may be formed of an insulating material such as silicon oxide and/or silicon nitride.

Cell gates CGmay be formed (S20). In an example, back gates (15 and 18) may be formed before forming the cell gates CG.

The forming of the back gates (15 and 18) may include forming back gate trenches allowing the cell semiconductor bodies 7c adjacent to each other with a first distance to be spaced apart from each other in a second horizontal direction Y and to be exposed and extending in a first horizontal direction X, forming insulating layers 12 partially filling the back gate trenches, forming a back gate dielectric layer 15 covering internal walls of the back gate trenches on the insulating layers 12, forming back gate electrodes 18 partially filling the back gate trenches on the back gate dielectric layer 15, and forming insulating layers 21 filling the other portions of the back gate trenches on the back gate electrodes 18.

The forming of the cell gates CG may include allowing the cell semiconductor bodies 7c adjacent to each other to be spaced apart from each other at a second distance that is greater than the first distance in the second horizontal direction Y and may further include allowing the cell semiconductor bodies 7c to be exposed, forming cell gate trenches extending in the first horizontal direction X, forming a cell gate dielectric layer 24 covering internal walls of the cell gate trenches, forming cell gate electrodes 27 facing the cell semiconductor bodies 7c adjacent to each other, respectively, on the cell gate dielectric layers 24, and forming insulating layers 30 and 33 to fill the other portions of the cell gate trenches in order on the cell gate electrodes 27.

One of the back gate electrodes 18 may be formed between the cell semiconductor bodies 7c adjacent to each other at the first distance.

A pair of cell gate electrodes 18 adjacent to each other, among the cell gate electrodes 27, may be formed between the cell semiconductor bodies 7c adjacent to each other at the second distance.

A pair of cell gate electrodes 27 adjacent to each other among the cell gate electrodes 27 may be formed between a pair of back gate electrodes 18 adjacent to each other among the back gate electrodes 18.

A first cell source/drain region 7c_sd1 may be formed in the cell semiconductor bodies 7c. The first cell source/drain regions 7c_sd1 may be formed in an upper region of each of the cell semiconductor bodies 7c.

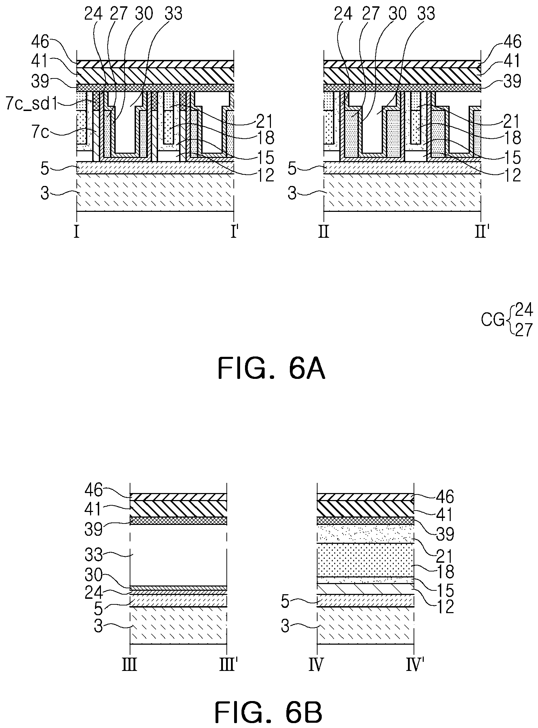

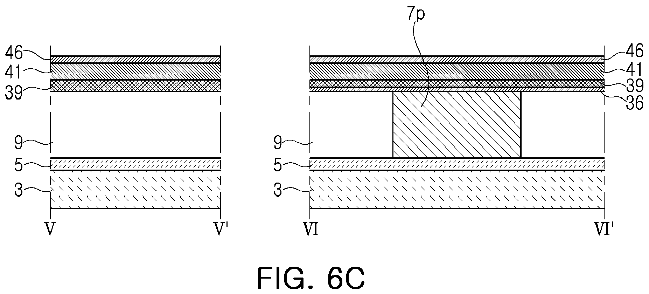

Referring to FIGS. 1A, 1B, 6A, 6B, and 6C, on a structure formed up to the first cell source/drain regions 7c_sd1, a peripheral gate dielectric layer 36 may be formed on the peripheral semiconductor body 7p, a plurality of conductive layers 39 and 41 sequentially stacked on a structure including the peripheral gate dielectric layer 36 may be formed, and a capping layer 46 may be formed on the plurality of conductive layers 39 and 41. The plurality of conductive layers 39 and 41 may include a first conductive layer 39 and a second conductive layer 41 that are sequentially stacked. The capping layer 46 may include an insulating material such as silicon nitride.

In an example embodiment, at least one of the plurality of conductive layers 39 and 41 formed in the cell array region CA and at least one of the plurality of conductive layers 39 and 41 formed in the peripheral region PA may be the same conductive layers formed by the same process. For example, the second conductive layer 41, among the plurality of conductive layers 39 and 41 formed in the cell array region CA, and the second conductive layer 41, among the plurality of conductive layers 39 and 41 formed in the peripheral region PA, may be the same.

In example embodiments, the first conductive layer 39, among the plurality of conductive layers 39 and 41 formed in the cell array region CA, and the first conductive layer 39, among the plurality of conductive layers 39 and 41 formed in the peripheral region PA, may be different from each other. For example, to adjust the threshold voltages of transistors having various threshold voltages formed in the peripheral region PA, the first conductive layer 39 formed in the peripheral region PA may be formed as a work function control layer for adjusting a threshold voltage of a transistor.

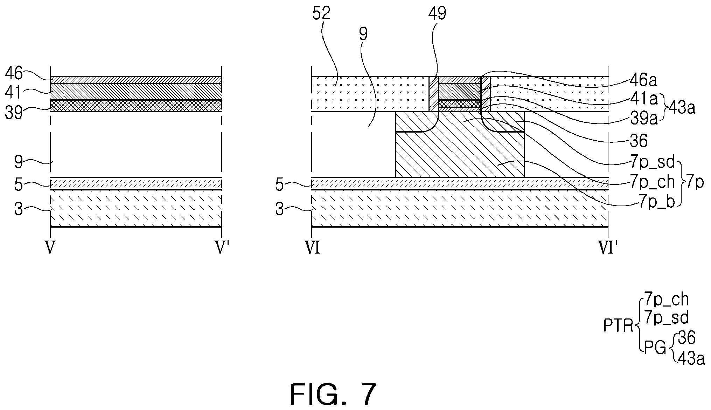

Referring to FIGS. 1A, 1B, and 7, a peripheral gate electrode 43a and a peripheral gate capping pattern 46a that are sequentially stacked may be formed by patterning the plurality of conductive layers (39 and 41 in FIG. 6C) and the capping layer (46 in FIG. 6C) in the peripheral region PA. The peripheral gate dielectric layer 36 may remain below the peripheral gate electrode 43a. The peripheral gate dielectric layer 36 and the peripheral gate electrode 43a may be included in a peripheral gate PG. The peripheral gate electrode 43a may include a plurality of conductive layers 39a and 41b that are sequentially stacked. A gate spacer 49 may be formed on side surfaces of the peripheral gate electrode 43a and the peripheral gate capping pattern 46a sequentially stacked.

Peripheral source/drain regions 7p_sd may be formed in the peripheral semiconductor body 7p on both sides of the peripheral gate PG.

Within the peripheral semiconductor body 7p, a region between the peripheral source/drain regions 7p_sd may be defined as a peripheral channel region 7p_ch, and a region below the peripheral source/drain regions 7p_sd and the peripheral channel region 7p_ch may be defined as a peripheral body region 7p_b. The peripheral body region 7p_b may also be referred to as a peripheral well region. The peripheral gate PG, the peripheral channel region 7p_ch, and the peripheral source/drain regions 7p_sd may be included in a peripheral transistor PTR.

Thereafter, an insulating material layer may be formed, and an insulating layer 52 may be formed by planarizing the insulating material layer until the peripheral gate capping pattern 46a and the upper surface of the capping layer 46 are exposed. The insulating layer 52 may include silicon oxide, a low-κ dielectric material, and/or silicon nitride. The insulating layer 52 may be formed on the peripheral source/drain regions 7p_sd and the device isolation layer 9.

Referring to FIGS. 1A, 1B, 4, 8A, 8B, and 8C, bit lines 43b and bit line capping patterns 46b sequentially stacked may be included by patterning the remaining conductive layers 39 and 41 and the capping layer 46. Each of the bit lines 43b may include a plurality of conductive layers 39b and 41b that are sequentially stacked. The bit lines 43b may be electrically connected to the first cell source/drain regions 7c_sd1.

The bit lines 43b may be disposed within the cell array region CA and may extend from the cell array region CA to a connection region IA adjacent to the cell array region CA. Accordingly, the bit lines 43b and the peripheral gate PG in the peripheral region PA may be formed (S30).

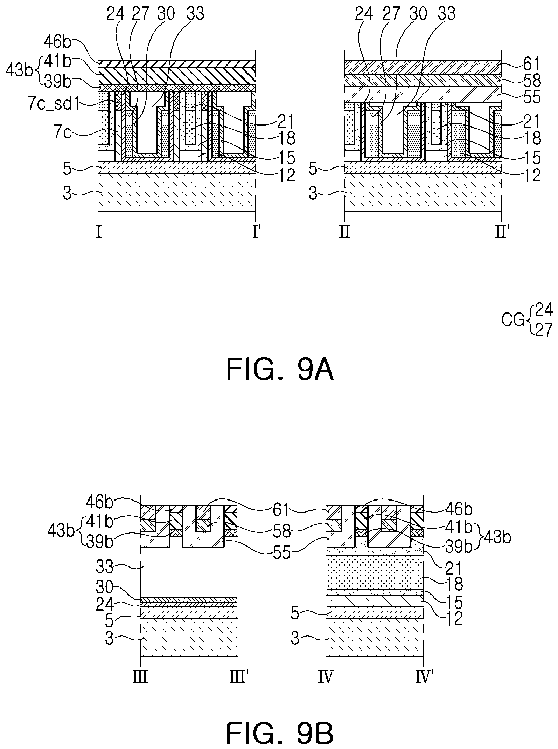

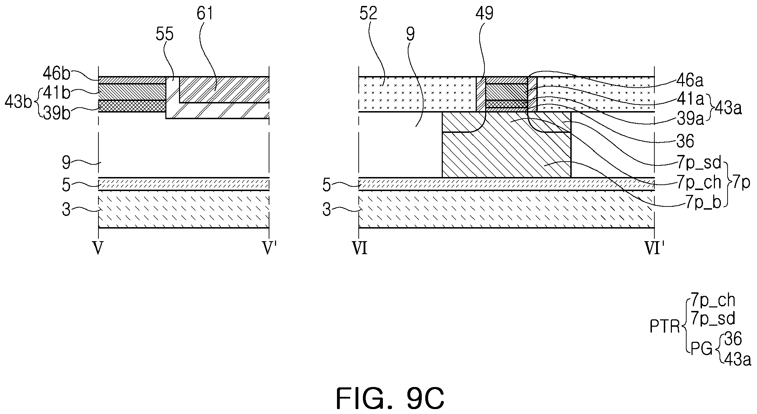

Referring to FIGS. 1A, 1B, 9A, 9B, and 9C, shield patterns 58 may be formed. Each of the shield patterns 58 may be disposed between bit lines adjacent to each other among the bit lines 43b.

In an example, the forming of the shield patterns 58 may include forming an insulating layer 55 conformally covering at least a space between the bit lines 43b, forming a conductive pattern partially filling a space between the bit lines 43b on the insulating layer 55, forming an insulating layer 61 on the conductive pattern, and planarizing until upper surfaces of the bit line capping patterns 46b and the peripheral gate capping pattern 46a are exposed.

In an example, the forming of the shield patterns 58 may include forming an insulating layer 55 conformally covering at least a space between the bit lines 43b, forming a conductive layer filling a space between the bit lines 43b and covering an upper portion of the bit line capping pattern 46b on the insulating layer 55, and removing the conductive layer and the insulating layer 55 in the peripheral region PA. Accordingly, the shield patterns 58 may be formed in a shape including a portion filling a region between the bit lines 43b and vertically overlapping the bit lines 43b.

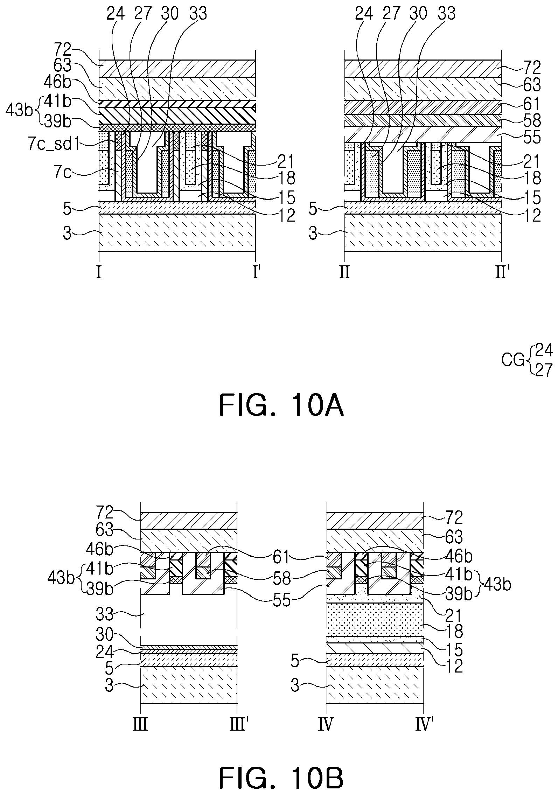

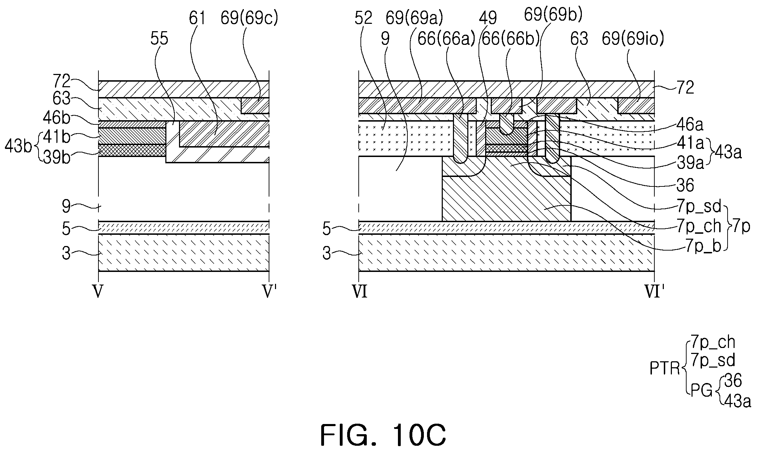

Referring to FIGS. 1A, 1B, 10A, 10B, and 10C, an insulating layer 63 may be formed. The insulating layer 63 may be formed as a single layer or a plurality of layers.

Lower wiring structures (66 and 69) electrically connected to the peripheral transistor PTR may be formed.

In an example, the lower wiring structures (66 and 69) may be formed using a dual damascene process. For example, the forming of the lower wiring structures (66 and 69) may include forming via holes and wiring trenches in the insulating layers 63, 52 and 46a, and forming a conductive material layer simultaneously filling the via holes and the wiring trenches. Accordingly, the lower wiring structures (66 and 69) may include lower contact plugs 66 filling the via holes and lower connection wirings 69 extending from the lower contact plugs 66 and filling the wiring trenches.

In an example, the forming of the lower wiring structures (66 and 69) may include forming the lower contact plugs 66 by a single damascene process and forming the lower connection wirings 69 by a single damascene process. Accordingly, since the lower contact plugs 66 and the lower connection wirings 69 are formed by different processes, a boundary surface may be formed between upper surfaces of the lower contact plugs 66 and lower surfaces of the lower connection wirings 69 in contact with each other.

In an example, the forming of the lower wiring structures (66 and 69) may include forming the lower contact plugs 66 through a single damascene process and forming the lower connection wirings 69 through a patterning process. Here, the patterning process may include depositing a conductive layer and subsequently etching the conductive layer through a photo and etching process. Accordingly, since the lower contact plugs 66 and the lower connection wirings 69 are formed by different processes, a boundary surface may be formed between upper surfaces of the lower contact plugs 66 and lower surfaces of the lower connection wirings 69 in contact with each other.

The lower contact plugs 66 and the lower connection wirings 69 may include a peripheral source/drain contact plug 66a electrically connected to the peripheral source/drain region 7p_sd, a peripheral source/drain lower connection wiring 69a electrically connected to the peripheral source/drain contact plug 66a, a peripheral gate contact plug 66b electrically connected to the peripheral gate electrode 43a, and a peripheral gate lower connection wiring 69b electrically connected to the peripheral gate contact plug 66b. The lower connection wirings 69 may include a bit line lower connection wiring 69c disposed in the connection region IA and extending into the peripheral region PA, and a peripheral lower connection wiring 69io disposed in the peripheral region PA. An insulating layer 72 may be formed on the insulating layer 63 and the lower connection wirings 69.

Referring to FIGS. 1A, 1B, 4, 11A, 11B, and 11C, a wafer bonding process may be performed (S40). The performing the wafer bonding process may include preparing a base substrate 75 and bonding a surface of the base substrate 75 to the insulating layer 72. The base substrate 75 may be a dummy semiconductor substrate including a material layer that is in contact with and bonded to the insulating layer 72 on a surface thereof.

Referring to FIGS. 1A, 1B, 4, 12A, 12B, and 12C, the cell semiconductor bodies 7c and the peripheral semiconductor body 7p may be exposed by removing the lower substrate 3 and the insulating layer 5 in that order.

Second cell source/drain regions 7c_sd2 may be formed in the cell semiconductor bodies 7c in the cell array region CA.

Within each of the cell semiconductor bodies 7c, a region between the first cell source/drain region 7c_sd1 and the second cell source/drain region 7c_sd2 may be defined as a cell vertical channel region 7c_ch. Accordingly, a cell vertical channel transistor CTR including the first and second cell source/drain regions 7c_sd1 and 7c_sd2, the cell vertical channel region 7c_ch, and the cell gate CG may be formed.

Insulating layers 78, 81, and 90 may be formed on a structure formed up to the cell vertical channel transistor CTR. The insulating layers 78, 81, and 90 may cover the cell semiconductor bodies 7c and the peripheral semiconductor body 7p.

Cell contact structures 84 and connection structures (86 and 88) may be formed (S50).

Each of the cell contact structures 84 may include a first contact layer 84a in contact with the cell semiconductor body 7c and electrically connected to the second cell source/drain region 7c_sd2, a second contact layer 84b on the first contact layer 84a, and a third contact layer 84c on the second contact layer 84b.

The forming of the cell contact structures 84 may include forming insulating layers 78 and 81, forming a hole penetrating the insulating layers 78 and 81, forming the first contact layer 84a partially filling the hole and in contact with the cell semiconductor body 7c, forming the second contact layer 84b in the hole, forming a conductive layer covering the other portion of the hole and covering the insulating layer 81 on the second contact layer 84b, and forming an insulating layer 90 penetrating through the conductive layer and the insulating layer 81. Within the cell array region CA, the insulating layer 90 may penetrate through the insulating layer 81 and may be in contact with the insulating layer 78.

In an example, the first contact layer 84a may be an epitaxial layer formed by an epitaxial growth process. For example, the first contact layer 84a may be an epitaxially grown silicon layer having N-type conductivity.

In an example, the first contact layer 84a may be a polysilicon layer having N-type conductivity.

The second contact layer 84b may be a metal-semiconductor compound layer.

The third contact layer 84c may be a metal layer. The third contact layer 84c may also be referred to as a landing pad.

The connection structures (86 and 88) may include connection contact plugs 86 and upper connection wirings 88.

In an example, the forming of the connection structures (86 and 88) may include forming contact holes, forming a conductive layer filling the contact holes and covering the insulating layer 78, and forming the insulating layer 90 penetrating the conductive layer and the insulating layer 81. The conductive layer remaining in the contact holes may be the connection contact plugs 86, and the conductive layer separated by the insulating layer 90 may be the upper connection wirings 88. The upper connection wirings 88 may extend from the connection contact plugs 86.

The connection contact plugs 86 may include a first connection contact plug 86a electrically connected to and in contact with the peripheral source/drain lower connection wiring 69a, a second connection contact plug 86b electrically connected to and in contact with the peripheral body region 7p_b of the peripheral semiconductor body 7p, a third connection contact plug 86c in contact with and electrically connected to the peripheral lower connection wiring 69io, a fourth connection contact plug 86d in contact with and electrically connected to the bit line 43b, and a fifth connection contact plug 86e in contact with and electrically connected to the bit line lower connection wiring 69c.

The upper connection wirings 88 may include a first upper connection wiring 88a electrically connected to the first connection contact plug 86a, a second upper connection wiring 88b electrically connected to the second connection contact plug 86b, a third upper connection wiring 88c electrically connected to the third connection contact plug 86c, and a fourth upper connection wiring 88d electrically connected to the fourth and fifth connection contact plugs 86d and 86e.

The first upper connection wiring 88a may extend into the peripheral region PA. The fourth upper connection wiring 88d and the first upper connection wiring 88a may be integrally formed.

Referring to FIGS. 1A, 1B, 2A, 2B, and 2C, an etch stop layer 92 covering the insulating layer 90, the cell contact structures 84, and the connection structures (86 and 88) may be formed.

A data storage structure 94 electrically connected to the contact structures 84 may be formed in the cell array region CA. The data storage structure 94 may include first electrodes 94a penetrating through the etch stop layer 92 and electrically connected to the contact structures 84, a dielectric layer 94b on the first electrodes 94a, and a second electrode 94c on the dielectric layer 94b.

An upper insulating layer 96 may be formed on the etch stop layer 92 in the peripheral region PA and the connection region IA, and an upper contact plug 98 penetrating through the upper insulating layer 96 and the etch stop layer 92 and electrically connected to the third upper connection wiring 88c may be formed.

In the above-described example embodiment, the forming of the bit line 43b and the peripheral gate electrode 43a may include forming a plurality of conductive layers (39 and 41 in FIGS. 6A to 6C) including at least one conductive layer identical to each other, forming the peripheral gate electrode 43a by patterning the plurality of conductive layers (39 and 41 in FIG. 6C) in the peripheral region PA, forming the bit line 43b by patterning the plurality of conductive layers (39 and 41 in FIGS. 6A to 6C) in the cell array region CA and the connection region IA, and forming the lower wiring structures (66 and 69).

In the above-described example embodiment, the bit line 43b and the peripheral gate electrode 43a may be formed using at least one conductive layer identical to each other.

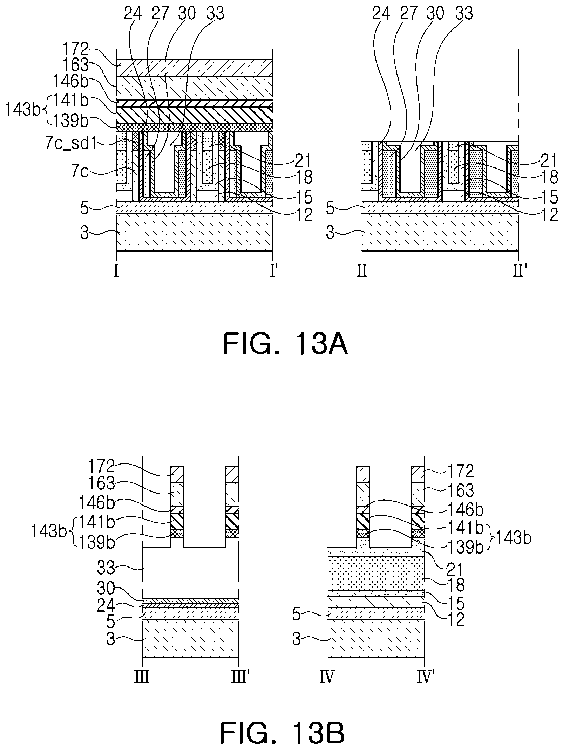

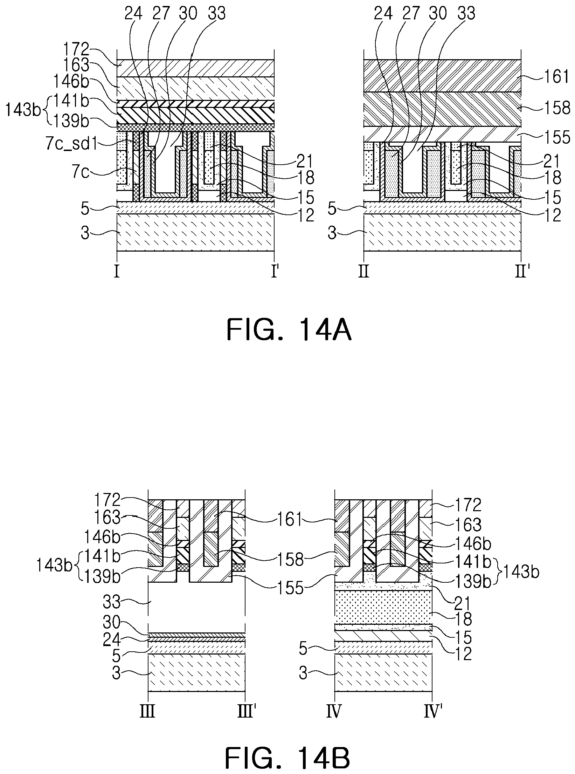

The method of manufacturing the above-described bit line 43b and the peripheral gate electrode 43a is not necessarily limited to the above-described example embodiment and may be modified in various manners. As described above, a modified example of a method of manufacturing the bit line 43b and the peripheral gate electrode 43a will be described with reference to FIGS. 13A to 14C. FIGS. 13A and 14A are cross-sectional diagrams illustrating regions taken along lines I-I' and II-II' in FIG. 1A, FIGS. 13B and 14B are cross-sectional diagrams illustrating regions taken along line III-III' in FIG. 1A, and FIGS. 13C and 14C are cross-sectional diagrams illustrating regions taken along line IV-IV' in FIG. 1A and V-V' in FIG. 1B.

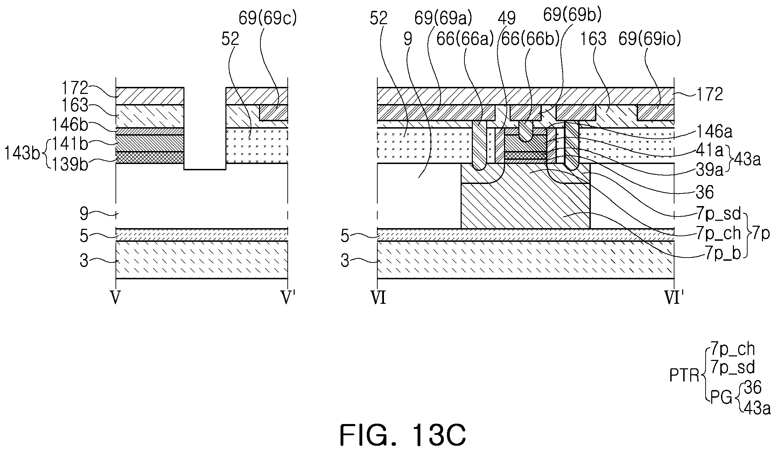

Referring to FIGS. 1A, 1B, 13A, 13B, and 13C, the conductive layers (39 and 41 in FIGS. 6A to 6C) sequentially stacked as described with reference to FIGS. 6A to 6C may be formed, and a structure formed up to the capping layer (46 in FIGS. 6A to 6C) on the conductive layers 39 and 41 may be prepared.

The peripheral transistor PTR, the peripheral gate capping pattern 46a, and the insulating layer 52 may be formed in the peripheral region PA by performing substantially the same process as the example described with reference to FIG. 7. The peripheral gate electrode 43a of the peripheral transistor PTR may be formed by patterning the conductive layers 39 and 41 in the peripheral region PA.

An insulating layer 163 covering the capping layer 46, the insulating layer 52, and the peripheral gate capping pattern 46a may be formed, and the lower wiring structure (66 and 69) as described with reference to FIGS. 10A to 10C may be formed. An insulating layer 172 may be formed on the insulating layer 163 and the lower wiring structures (66 and 69).

The conductive layers (39 and 41 in FIGS. 6A to 6C), the capping layer 46, and the insulating layers 163 and 172 in the cell array region CA and the connection region IA may be patterned. In the cell array region CA and the connection region IA, the conductive layers (39 and 41 in FIGS. 6A to 6C) may be patterned and may be formed as bit lines 143b. Accordingly, each of the bit lines 143b may include conductive layers 139b and 141b formed by patterning the conductive layers (39 and 41 in FIGS. 6A to 6C). A capping layer 146b and insulating layers 163 and 172 patterned on each of the bit lines 143b may remain.

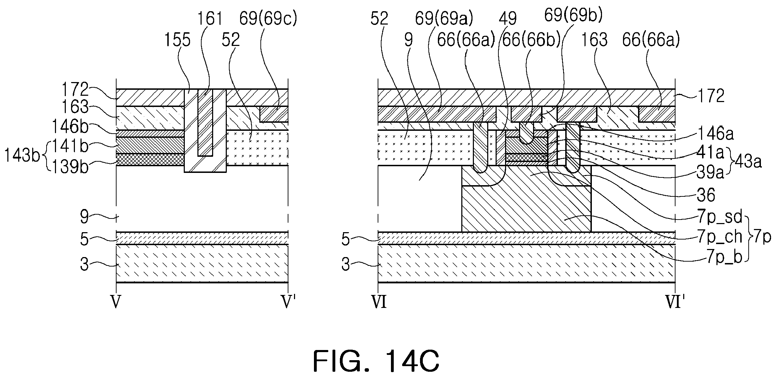

Referring to FIGS. 1A, 1B, 14A, 14B, and 14C, shield patterns 158 may be formed. Each of the shield patterns 158 may be disposed between bit lines adjacent to each other among the bit lines 143b. The forming of the shield patterns 158 may include forming an insulating layer 155 conformally covering at least a space between the bit lines 143b, forming a conductive pattern partially filling a space between the bit lines 143b on the insulating layer 155, forming an insulating layer 161 on the conductive pattern, and planarizing until the insulating layer 172 is exposed.

In the above-described example embodiment, the forming of the bit line 143b and the peripheral gate electrode 43a may include forming a plurality of conductive layers (39 and 41 in FIGS. 6A to 6C) including at least one conductive layer identical to each other, forming the peripheral gate electrode 43a by patterning the plurality of conductive layers (39 and 41 in FIG. 6C) in the peripheral region PA, forming the lower wiring structures (66 and 69), and forming the bit line 143b by patterning the plurality of conductive layers (39 and 41 in FIGS. 6A to 6C) in the cell array region CA and the connection region IA.

In the above-described example embodiment, the bit line 143b and the peripheral gate electrode 43a may be formed using at least one conductive layer identical to each other.

According to the aforementioned example embodiments, a semiconductor device including a vertical channel transistor, a peripheral gate, and a bit line can be provided. The bit line is disposed at a level that is lower than a level of the vertical channel transistor, at least a portion of the bit line and at least a portion of the peripheral gate are disposed at the same level and may include the same material. By providing the vertical channel transistor, the peripheral gate, and the bit line, integration density of the semiconductor device may be increased, reliability of the semiconductor device may be increased, and electrical performance of the semiconductor device may be increased.

While the example embodiments have been illustrated and described above, it will be apparent to those skilled in the art that modifications and variations could be made without departing from the scope of the present disclosure.

## Claims

1. A semiconductor device, comprising:
a vertical channel transistor including a vertical channel region extending in a vertical direction and a cell gate electrode facing a first side surface of the vertical channel region;
a bit line electrically connected to the vertical channel transistor at a level that is lower than a level of the vertical channel transistor;
a peripheral semiconductor body, at least a portion of which is at a same level as the vertical channel region;
peripheral source/drain regions disposed in the peripheral semiconductor body and spaced apart from each other in a horizontal direction that is perpendicular to the vertical direction;
a peripheral channel region disposed in the peripheral semiconductor body and disposed between the peripheral source/drain regions; and
a peripheral gate that is below the peripheral semiconductor body,
wherein at least a portion of the peripheral gate is at a same level as at least a portion of the bit line.

2. The semiconductor device of claim 1,
wherein the peripheral gate includes a peripheral gate electrode disposed below the peripheral semiconductor body and a peripheral gate dielectric layer disposed between the peripheral gate electrode and the peripheral semiconductor body, and
wherein at least a portion of the peripheral gate electrode includes a same conductive material as at least a portion of the bit line.

3. The semiconductor device of claim 1 or 2,
wherein the vertical channel transistor further includes a first cell source/drain region and a second cell source/drain region at a level that is higher than a level of the first cell source/drain region,
wherein the vertical channel region is disposed between the first cell source/drain region and the second cell source/drain region, and
wherein the bit line is electrically connected to the first cell source/drain region.

4. The semiconductor device of claim 3, further comprising:
a contact structure disposed on the second cell source/drain region; and
a data storage structure disposed on the contact structure.

5. The semiconductor device of claim 4,
wherein the contact structure includes a first contact layer that is electrically connected to the second cell source/drain region,
wherein the first contact layer includes silicon, and
wherein a vertical central axis of the first contact layer is not aligned with a vertical central axis of the vertical channel region.

6. The semiconductor device of claim 5,
wherein the contact structure further includes a second contact layer disposed on the first contact layer and a third contact layer that is disposed on the second contact layer,
wherein the first contact layer, the second contact layer, and the third contact layer include different materials, and
wherein the data storage structure is electrically connected to the third contact layer.

7. The semiconductor device of claim 4, 5, or 6 wherein the first cell source/drain region, the vertical channel region, and the second cell source/drain region are disposed in a single crystal silicon pattern.

8. The semiconductor device of any one of claims 1 to 7, further comprising:
a lower connection wiring disposed at a level that is lower than a level of the peripheral gate and the bit line;
an upper connection wiring disposed at a level that is higher than both a level of the peripheral semiconductor body and a level of the vertical channel transistor;
a peripheral connection contact plug electrically connecting the upper connection wiring to the lower connection wiring, between the upper connection wiring and the lower connection wiring; and
a bit line connection contact plug electrically connecting the upper connection wiring to the bit line, between the upper connection wiring and the bit line.

9. The semiconductor device of claim 8,
wherein the bit line connection contact plug extends into the bit line and is in contact with the bit line, and
wherein the peripheral connection contact plug extends into the lower connection wiring and is in contact with the lower connection wiring.

10. The semiconductor device of any one of claims 1 to 9, further comprising:
a back gate electrode facing a second side surface of the vertical channel region; and
a back gate dielectric layer disposed between the second side surface of the vertical channel region and the back gate electrode,
wherein the vertical channel transistor further includes a cell gate dielectric layer disposed between the first side surface of the vertical channel region and the cell gate electrode.

11. The semiconductor device of any one of claims 1 to 10,
wherein the peripheral gate includes a peripheral gate electrode disposed below the peripheral channel region and a peripheral gate dielectric layer disposed between the peripheral gate electrode and the peripheral channel region,
wherein at least a portion of the peripheral gate electrode is disposed at a same level as at least a portion of the bit line,
wherein the bit line includes a plurality of first conductive layers that are sequentially stacked,
wherein the peripheral gate electrode includes a plurality of second conductive layers that are sequentially stacked, and
wherein at least one of the plurality of first conductive layers includes a same material as at least one of the plurality of second conductive layers.

12. The semiconductor device of any one of claims 1 to 11, further comprising:
a shield pattern disposed on a side surface of the bit line and including a conductive material; and
an insulating layer disposed between the bit line and the shield pattern.

13. A method of manufacturing a semiconductor device, comprising:
providing a vertical channel transistor including a vertical channel region extending in a vertical direction and a cell gate electrode facing a first side surface of the vertical channel region;
providing a bit line electrically connected to the vertical channel transistor at a level that is lower than a level of the vertical channel transistor;
providing a peripheral semiconductor body, at least a portion of which is at a same level as the vertical channel region;
providing peripheral source/drain regions disposed in the peripheral semiconductor body and spaced apart from each other in a horizontal direction that is perpendicular to the vertical direction;
providing a peripheral channel region disposed in the peripheral semiconductor body and disposed between the peripheral source/drain regions; and
providing a peripheral gate that is below the peripheral semiconductor body,
wherein at least a portion of the peripheral gate is at a same level as at least a portion of the bit line.

14. The method of claim 13, wherein providing the peripheral gate includes providing a peripheral gate electrode disposed below the peripheral semiconductor body and a peripheral gate dielectric layer disposed between the peripheral gate electrode and the peripheral semiconductor body, and wherein at least a portion of the peripheral gate electrode includes a same conductive material as at least a portion of the bit line.

15. The method of claim 13 or 14, wherein providing the vertical channel transistor further includes providing a first cell source/drain region and a second cell source/drain region at a level that is higher than a level of the first cell source/drain region, wherein the vertical channel region is disposed between the first cell source/drain region and the second cell source/drain region, and wherein the bit line is electrically connected to the first cell source/drain region.
